# EUROPEAN PATENT APPLICATION

(11) **EP 2 086 015 A2**
(43) Date of publication of application: **05.08.2009**
(21) Application number: 08166200.9
(22) Date of filing: 09.10.2008
(51) Int. Cl.: H01L 31/0224, H01L 31/0352

(54) **Solar Cell and Method for Manufacturing the same**

(30) Priority: 25.01.2008 KR 20080007991
(71) Applicant: Samsung SDI Co., Ltd., Gyeonggi-do (KR)
(72) Inventor: Moon, In-Sik, Samsung SDI Co., Ltd., Suwon-si, Gyeonggi-do (KR); Kim, Dae-Won, Samsung SDI Co., Ltd., Suwon-si, Gyeonggi-do (KR)
(74) Representative: Perkins, Dawn Elizabeth

(57) **Abstract**

A method for manufacturing a solar cell having an improved process and a solar cell manufactured by the method include a semiconductor substrate having a via hole, an emitter portion, a base portion, a first electrode, and a second electrode. The emitter portion and the base portion form a p-n junction in the semiconductor substrate. The first electrode is electrically connected to the emitter portion, and the second electrode is electrically connected to the base portion. Conductive crystals are formed to electrically connect a first electrode portion of the first electrode and the emitter portion to increase the efficiency of the solar cell.

## Description

Aspects of the present invention relate to a solar cell and a method for manufacturing the same. More particularly, aspects of the present invention relate to a method for manufacturing a solar cell having an improved process and a solar cell manufactured by the method.

A solar cell generates electrical energy from solar energy. The solar cell is environmentally friendly, and its energy source is near endless. In addition, the solar cell has a long lifespan. Examples of the solar cell include a semiconductor solar cell and a dye-sensitized solar cell according to a scheme of generating electrical energy from solar energy.

In the semiconductor solar cell, a base portion and an emitter portion are formed in a semiconductor substrate, which have different conductive types, to form a p-n junction. A first electrode is electrically connected to the emitter portion, and a second electrode is electrically connected to the base portion. An anti-reflective layer may be formed on the front surface of the semiconductor substrate.

Generally, the first electrode is formed on a front surface of the semiconductor substrate, and the second electrode is formed on a rear surface of the semiconductor substrate. However, if the first electrode is formed with a large area to reduce resistance, the first electrode blocks light that is incident on the front surface of the semiconductor substrate, and thus shading loss due to the first electrode increases.

In order to reduce the shading loss, a solar cell in which the first electrode includes a front portion formed on the front surface of the semiconductor substrate and a rear portion formed on the rear surface of the semiconductor substrate and connected to the front portion through a via hole has been suggested.

The front portion and the rear portion may be formed by applying a paste for forming an electrode and firing the same. In the firing process of the front portion and the rear portion, a heat treatment is performed so that a firing through process in which the paste for forming the electrode etches the anti-reflective layer is generated. By the firing through process, the first electrode is electrically connected to the emitter portion.

However, the anti-reflective layer is relatively thick on the front surface of the semiconductor substrate and is relatively thin on the rear surface of the semiconductor substrate and on the inner wall of the via hole. Selectively, the anti-reflective layer may be not formed on the inner wall of the via hole. In addition, the emitter portion is relatively thin on the rear surface of the semiconductor substrate and on the inner wall of the via hole. Thus, in the firing process, the paste for forming the electrode formed on the rear surface of the semiconductor substrate and on the inner wall of the via hole may damage the emitter thereby generating a shunt or short circuit and a fill factor or energy conversion efficiency of the solar cell is deteriorated.

The above information disclosed in this Background section is only for enhancement of understanding of the background of the invention and therefore it may contain information that does not form the prior art that is already known in this country to a person of ordinary skill in the art.

Aspects of the present invention have been made to provide a solar cell and a method for manufacturing the same having advantages of preventing a shunt between a first electrode and emitter portion, thereby improving a fill factor and energy conversion efficiency.

According to aspects of the present invention, a solar cell includes a semiconductor substrate including a via hole, an emitter portion, a base portion, a first electrode, and a second electrode. According to aspects of the present invention, the semiconductor substrate has a first surface on which light is incident and a second surface opposite to the first surface. According to aspects of the present invention, the emitter portion is formed adjacent to the first surface of the semiconductor substrate, the second surface of the semiconductor substrate, and a wall of the via hole. According to aspects of the present invention, the base portion forms a p-n junction in the semiconductor substrate along with the emitter portion. According to aspects of the present invention, the first electrode is electrically connected to the emitter portion. According to aspects of the present invention, the second electrode is electrically connected to the base portion. According to aspects of the present invention, the first electrode includes a first electrode portion formed on the first surface of the semiconductor substrate, a second electrode portion formed on the second surface of the semiconductor substrate, and connecting electrode portion to connect the first electrode portion to the second electrode portion through the via hole. According to aspects of the present invention, a first interface between the first electrode portion and the emitter portion has a different structure from a second interface between the second electrode portion and the emitter portion and between the connecting electrode portion and the emitter portion.

According to aspects of the present invention, a plurality of conductive crystals electrically connect the emitter portion and the first electrode portion, and the plurality of conductive crystals is formed in the first interface and the crystals of the plurality of conductive crystals are spaced apart from each other. According to aspects of the present invention, the conductive crystals may have inverted pyramid or cone shapes.

According to aspects of the present invention, the second interface and the emitter portion may form a surface opposing structure in which no conductive crystals are formed. According to aspects of the present invention, the connecting electrode portion may contact the emitter portion in the via hole.

According to aspects of the present invention, the solar cell may further include an insulating layer. According to aspects of the present invention, the insulating layer may include a first insulating portion formed on the first surface of the semiconductor substrate and a second insulating portion formed on the inner wall of the via hole. According to aspects of the present invention, the second insulation portion may be positioned between the second electrode portion and the emitter portion.

According to aspects of the present invention, the second insulating portion may cover the inner wall of the via hole. The insulating layer may be an anti-reflective layer, and may be formed of silicon nitride.

According to aspects of the present invention, a method for manufacturing a solar cell includes preparing a semiconductor substrate, applying a paste for forming a first electrode portion, performing a first heat treatment, applying a paste for forming a second electrode portion and a connecting electrode portion, and performing a second heat treatment. According to aspects of the present invention, in the preparing of the semiconductor substrate, the semiconductor substrate includes a base portion and an emitter portion to form a p-n junction, and has a via hole. According to aspects of the present invention, in the applying of the paste for forming the first electrode portion, the paste is applied on the first surface of the semiconductor substrate. According to aspects of the present invention, in the performing of the first heat treatment, the paste for forming the first electrode portion is heat-treated at a first temperature to form a first electrode. According to aspects of the present invention, in the applying of the paste for forming the second electrode portion and the connecting electrode portion, the pasted is applied on the second surface of the semiconductor substrate and inside the via hole. According to aspects of the present invention, in the performing of the second heat treatment, the paste for forming the second electrode portion and the connecting electrode portion is heat-treated at a second temperature that is lower than the first temperature to form a second electrode portion of the first electrode.

According to aspects of the present invention, in the performing of the first heat treatment, a plurality of conductive crystals, which are electrically connected to the emitter portion and are spaced apart from each other, may be formed at a first interface between the first electrode and the emitter portion. According to aspects of the present invention, the conductive crystals may have inverted pyramid or cone shapes.

According to aspects of the present invention, in the performing of the first heat treatment, a firing through process may be generated.

According to aspects of the present invention, the second interface and the emitter may form a surface opposing structure in which no conductive crystals are formed. According to aspects of the present invention, in the performing of the second heat treatment, it is possible that a firing through process is not generated.

According to aspects of the present invention, the method may further include forming an insulating layer on the first surface of the semiconductor substrate and on an inner wall of the via hole between the preparing of the semiconductor substrate and the applying of the paste for forming the first electrode portion. According to aspects of the present invention, the paste for forming the first electrode portion may etch a first insulating portion of the insulating layer formed on the first surface of the semiconductor substrate in the performing of the first heat treatment. According to aspects of the present invention, the paste for forming the second electrode portion does not etch a second insulating portion of the insulating layer formed on the inner wall of the via hole in the performing of the second heat treatment.

According to aspects of the present invention, the paste for forming the first electrode portion may include the same material as the paste for forming the second electrode portion and the connecting electrode portion.

According to aspects of the present invention, the method may further include applying a paste for forming a second electrode on the second surface of the semiconductor substrate after the preparing of the semiconductor substrate and before the applying of the paste for forming the first electrode portion. According to aspects of the present invention, the paste for forming the second electrode is heat-treated in the performing of the first heat treatment to form the second electrode.

According to aspects of the present invention, the emitter portion may be formed adjacent to the first surface of the semiconductor substrate and may extend to the second surface of the semiconductor substrate at a portion adjacent to the via hole.

According to aspects of the present invention, the first temperature may be 650°C to 850°C. According to aspects of the present invention, the second temperature may be 200°C to 600°C.

According to aspects of the present invention, the insulating layer may be an anti-reflective layer, and may be formed of silicon nitride.

According to the method for manufacturing the solar cell according to aspects of the present invention, the first heat treatment to form the first electrode portion and the second heat treatment to form the second electrode portion and the connecting electrode portion are performed at different temperatures considering the material of electrode portions.

According to aspects of the present invention, the firing through process is generated in the performing of the first heat treatment, and thus the first electrode portion can be excellently connected to the emitter portion. According to aspects of the present invention, the firing through process is not generated in the performing of the second heat treatment, and thus shunts between the second electrode portion and the emitter portion and the connecting electrode portion can be effectively prevented. According to aspects of the present invention, the shunt resistance of the solar cell can be minimized, and a fill factor and energy conversion efficiency can be improved.

According to aspects of the present invention, the paste for forming the first electrode portion is the same material as the paste for forming the second electrode and the connecting electrode portion to thereby simplify the manufacturing process of the solar cell.

According to aspects of the present invention, a separate process is not needed, and new manufacturing facilities are not needed. Thus, the solar cell according to aspects of the present invention having the excellent energy conversion efficiency can be formed by a simple manufacturing process with existing facilities.

Additional aspects and/or advantages of the invention will be set forth in part in the description which follows and, in part, will be obvious from the description, or may be learned by practice of the invention.

These and/or other aspects and advantages of the invention will become apparent and more readily appreciated from the following description of the embodiments, taken in conjunction with the accompanying drawings of which:
FIG. 1 is a top plan view showing a solar cell according to an exemplary embodiment of the present invention;
FIG. 2 is a cross-sectional view taken along a line II-II of FIG. 1;
FIG. 3 is a cross-sectional view taken along a line III-III of FIG. 1;
FIG. 4 is a flowchart showing a method for manufacturing a solar cell according to an exemplary embodiment of the present invention;
FIG. 5A to FIG. 5I are cross-sectional views, each showing a step of the method for manufacturing a solar cell according to an exemplary embodiment of the present invention;
FIG. 6A to FIG. 6E are pictures showing how to form conducive crystals by a firing through process;
FIG. 7A is a picture of an interface of a first electrode portion formed under the same conditions as in an experimental example, excepting that a texturing process is not performed; and
FIG. 7B is a picture of an interface of a second electrode portion formed by the experimental example.

Reference will now be made in detail to the present embodiments of the present invention, examples of which are illustrated in the accompanying drawings, wherein like reference numerals refer to the like elements throughout. The embodiments are described below in order to explain the aspects of the present invention by referring to the figures. Throughout this specification and the claims that follow, when it is described that an element is "connected to" or "formed on" or "disposed on" another element, the element may be directly connected to or directly formed on or directly disposed on the other element or connected to or formed on or disposed on the other element through a third element. Further, such connections may be electrical or mechanical but are not limited thereto. In addition, unless explicitly described to the contrary, the word "comprise" and variations such as "comprises" or "comprising" will be understood to imply the inclusion of stated elements but not the exclusion of any other elements.

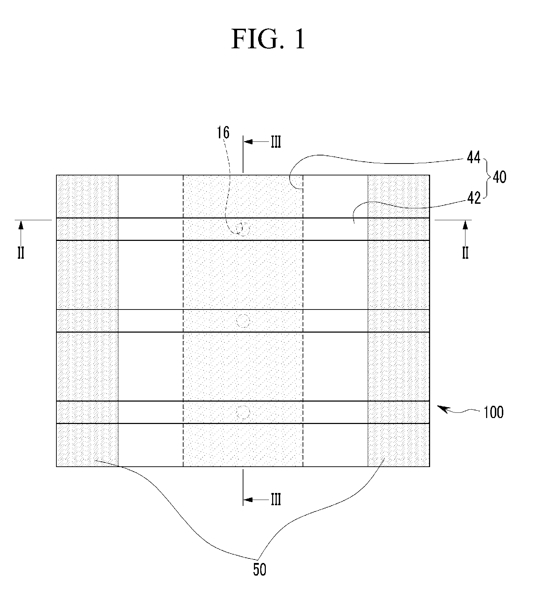

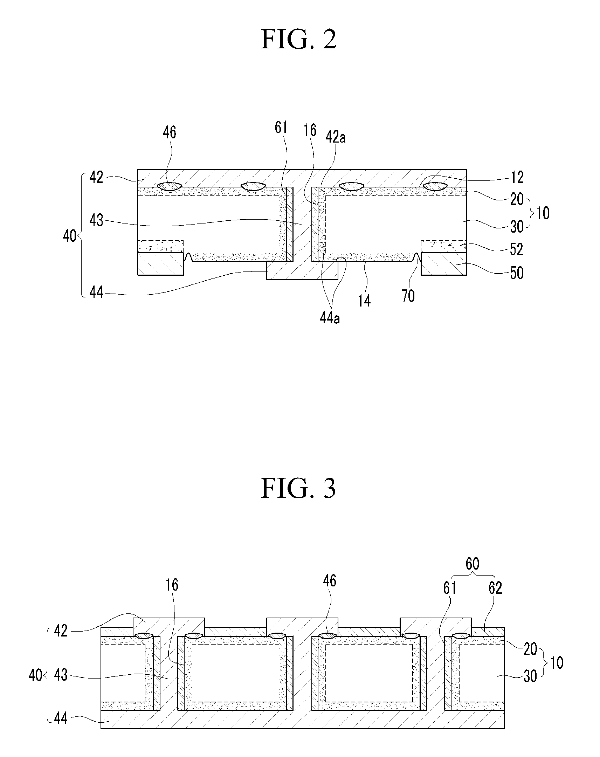

FIG. 1 is a top plan view showing a solar cell according to an exemplary embodiment of the present invention. FIG. 2 is a cross-sectional view taken along a line II-II of FIG. 1, and FIG. 3 is a cross-sectional view taken along a line III-III of FIG. 1. Referring to FIGs. 1 to 3, a solar cell 100 according to the present exemplary embodiment includes a semiconductor substrate 10 having an emitter portion 20 and a base portion 30. The emitter portion 20 and the base portion 30 are of different conductive types and form a p-n junction. The solar cell 100 also includes at least one first electrode 40 electrically connected to the emitter portion 20, and at least one second electrode 50 electrically connected to the base portion 30. The semiconductor substrate 10 includes at least one via hole 16, and an insulating layer 60 is formed on at least a portion of the first surface (hereinafter, "front surface") 12 and inside the via hole 16. Here, the front surface 12 represents a surface on which light is incident and transmitted therethrough.

Hereinafter, the solar cell 100 will be described in more detail. The emitter portion 20 is formed on the front surface 12 of the semiconductor substrate 10, and extends to a second surface (hereinafter, "rear surface") 14 of the semiconductor substrate 10 through a via hole 16. The emitter portion 20 may be formed of an n-type crystalline silicon. However, the emitter portion 20 may be formed of a p-type crystalline silicon or may be formed of various materials.

The base portion 30 is a portion of the semiconductor substrate 10 where the emitter portion 20 is not formed in the semiconductor substrate 10, and the base portion 30 is formed of a p-type crystalline silicon to from a p-n junction along with the emitter portion 20. However, aspects of the present invention are not limited thereto. Thus, if the emitter portion 20 is a p-type semiconductor, the base portion 30 of the substrate 10 is formed of an n-type semiconductor. In addition, the base portion 30 may be formed of various materials.

The first electrode 40 is electrically connected to the emitter portion 20 and is formed on both of the front surface 12 and the rear surface 14 of the semiconductor substrate 10 and connected therebetween through the via hole 16 in the semiconductor substrate 10. In more detail, the first electrode 40 includes a first electrode portion 42 formed on the front surface 12 of the semiconductor substrate 10, a second electrode portion 44 formed on the rear surface 14 of the semiconductor substrate 10, and the first and second electrode portions 42 and 44 are connected through the via hole 16 by a connecting electrode portion 43. Electrons generated at the emitter portion 20 along the front surface 12 of the semiconductor substrate 10 are collected by the first electrode portion 42 and moved to the second electrode portion 44 through the via hole 16 by the connecting electrode portion 43. The first electrode 40 may be formed of silver (Ag), as an example. However, aspects of the present invention are not limited thereto, and the first electrode 40 may be formed of various materials.

As shown in FIG. 1, the first electrode portion 42 extends along the front surface 12 of the semiconductor substrate 10 in a first direction, and the second electrode portion 44 extends along the rear surface 14 of the semiconductor substrate 10 in a second direction, which crosses the first direction. The first electrode portion 42 and the second electrode portion 44 are connected by the connecting electrode portion 43 through the via hole 16. However, aspects of the present invention are not limited to such structure such that the first electrode portion 42 and the second electrode portion 44 may be of various shapes.

As shown in FIG. 3, an insulating layer 60 is formed at least on the front surface 12 of the semiconductor substrate 10. The insulating layer 60 may be an anti-reflective layer and prevents the loss of light induced by reflection at the front surface 12 of the semiconductor substrate 10. In addition, the insulating layer 60 prevents charges from recombining with defects, such as dangling bonds, located on the front surface 12 of the semiconductor substrate 10. The insulating layer 60 may be formed of a silicon-nitrogen compound (Si_{y}Nₓ), such as silicon nitride (Si₃N₄).

With reference to FIGs. 2 and 3, a first interface 42a of the first electrode portion 42 facing the emitter portion 20 has a different structure from a second interface 44a of the connecting electrode portion 43 and the second electrode portion 44 facing the emitter portion 20. In more detail, a plurality of conductive crystals 46 are formed at the first interface 42a of the first electrode portion 42; whereas no conductive crystals 46 are formed at the second interface 44a. The conductive crystals 46 are electrically connected to the emitter portion 20 and are spaced apart from each other. The conductive crystals 46 may have inverted pyramid or cone shapes formed by crystallization of a metal material included in the first electrode portion 42. The conductive crystals 46 may include silver (Ag). The conductive crystals 46 may be formed by a firing through process. The first electrode portion 42 is formed by the firing through process to form the conductive crystals 46 at the first interface 42a of the first electrode portion 42. The conductive crystals 46 provide excellent electrical conduction between and electrically connect the first electrode portion 42 to the emitter portion 20. Thus the first electrode portion 42 can effectively collect charges.

The second interface 44a of the connecting electrode portion 43 and the emitter 20 and the second electrode portion 44 and the emitter 20 form a surface opposing structure. Here, the surface opposing structure is a structure in which the second interface 44a and the emitter 20 face each other without conductive crystals 46 formed therebetween. The surface opposing structure may be formed by forming the connecting electrode portion 43 and the second electrode portion 44 without a firing through process. The second electrode portion 44 is formed by a process other than the firing through process so that the connecting electrode portion 43 and the second electrode portion 44 have the surface opposing structure with the emitter portion 20 with no conductive crystals 46 formed therebetween. The connecting electrode portion 43 and the second electrode portion 44 are formed not by the firing through process, thereby preventing a shunt. In more detail, before heat-treatment for forming electrodes, an insulating layer may be formed on the inner wall of the via hole 16, which is thinner than an insulating layer formed on the front surface 12 of the semiconductor substrate 10. Therefore, if the connecting electrode portion 43 and the second electrode portion 44 are formed by the firing through process induced at a high-temperature heat-treatment for forming electrodes, a shunt may be generated in the portion adjacent the rear surface 14 of the semiconductor substrate 10 and the inner wall of the via hole 16. As such, in the present exemplary embodiment, the connecting electrode portion 43 and the second electrode portion 44, which are formed at the portions where shunts are easily generated, are formed without the firing through process. Accordingly, the shunts can be effectively prevented.

Whether the firing through process is used in the forming of the first electrode portion 42, the connecting electrode portion 43, and the second electrode portion 44 is indicated by the presence of the conductive crystals 46 formed between the insulating layer 60 and the first electrode portion 42, the connecting electrode portion 43, and the second electrode portion 44. The insulating layer 60 includes the first insulating portion 61 formed on the front surface 12 of the semiconductor substrate 10 at portions in which the first electrode portion 42 is not formed, and the second insulating portion 62 formed on an inner wall of the via hole 16, but aspects of the present invention are not limited thereto such that the second insulating portion 62 is not provided or may also be formed on the rear surface 14 of the semiconductor substrate. The second insulating portion 62 is a film or a layer formed on the entirety or most of inner walls of the via hole 16. The second insulating portion 62 is formed between a portion of the connecting electrode portion 43 formed on the inner wall of the via hole 16 and the emitter portion 20.

When the first electrode portion 42 is formed by the firing through process, the insulating portion under the first electrode portion 42 is etched by the firing through process, and the insulating portion of the insulating layer 60 remains in the etched portions corresponding to the first electrode portion 42 in a small amount or is completely removed. However, the first insulating portion 61 of the insulating layer 60 remains on portions of the semiconductor substrate 10 in which the first electrode portion 42 is not formed.

The insulating portion remains in a small amount or is completely removed under the first electrode portion 42. Thus, it can be determined that the first electrode portion 42 is formed by the firing through process. The second insulating portion 62 exists as a film or layer formed on the entirety or most of the inner wall of the via hole 16. Thus, it can be determined that the connecting electrode portion 43 is formed without the firing through process. Further, when the second insulating portion 62 is formed on the rear substrate 14 between the emitter portion 20 and the second electrode portion 44, the second insulating portion 62 remains therebetween as the second electrode portion 44 is formed by a process other than the firing through process. Moreover, aspects of the present invention are not limited thereto. The second insulating portion 62 may not be necessary, and the second insulating portion 62 may not be formed during the forming of the insulating layer 60. In such case, the connecting electrode portion 43 is in contact with the emitter portion 20 in the via hole 16 and the connecting electrode portion 43 formed having the surface opposing structure with the emitter portion 20.

The second electrode 50 is electrically connected to the base portion 30 and is formed to be spaced apart from the second electrode portion 44 on the rear surface 14 of the semiconductor substrate 10. The second electrode portion 44 is separated from the second electrode 50 by an insulating part 70 formed on or in the rear surface 14 of the semiconductor substrate 10. The second electrode 50 may be formed of aluminum (Al). Further, the second electrode 50 is formed on a portion of the rear surface 14 in which the emitter portion 20 is not formed, i.e., a portion of the semiconductor substrate 10 in which the base portion 30 is exposed. Also, the second electrode 50 is not connected to the emitter portion 20, i.e., the insulating part 70 insulates the second electrode 50 from the emitter portion 20 and the second electrode portion 44 of the first electrode 40.

A rear surface electric field layer 52 is formed at a portion of the base portion 30 of the semiconductor substrate 10 in which the base portion 30 is exposed, and the rear surface electric field layer 52 is formed adjacent to the second electrode 50. The rear surface electric field layer 52 is a portion of the base portion 30 of the semiconductor substrate 10 that is a highly concentrated p-type semiconductor. The rear surface electric field layer 52 is formed by diffusing a conductive material, such as aluminum, from the second electrode 50 to a predetermined thickness in the base portion 30 of the semiconductor substrate 10. The rear electric field layer 52 prevents photo-excited electrons from being lost at the rear surface 14 of the semiconductor substrate 10. Although the rear surface electric field layer 52 is described as a highly conductive p-type semiconductor, aspects of the present invention are not limited thereto such that, if the base portion 30 is an n-type semiconductor, the rear surface electric field layer 52 may be a highly conductive n-type semiconductor.

When light is incident to the solar cell 100, a positive hole and an electron formed by a photoelectric effect are separated, and the separated electrons are accumulated in the n-type emitter portion 20, whereas the separated positive holes are accumulated in the p-type base portion 30. The charges are collected by the first and second electrodes 40 and 50 thereby creating a voltage potential between the first and second electrodes 40 and 50; and thus, the solar cell generates electricity.

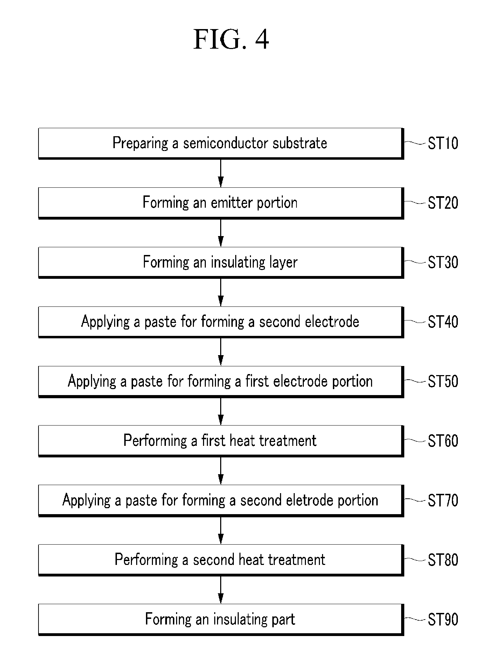

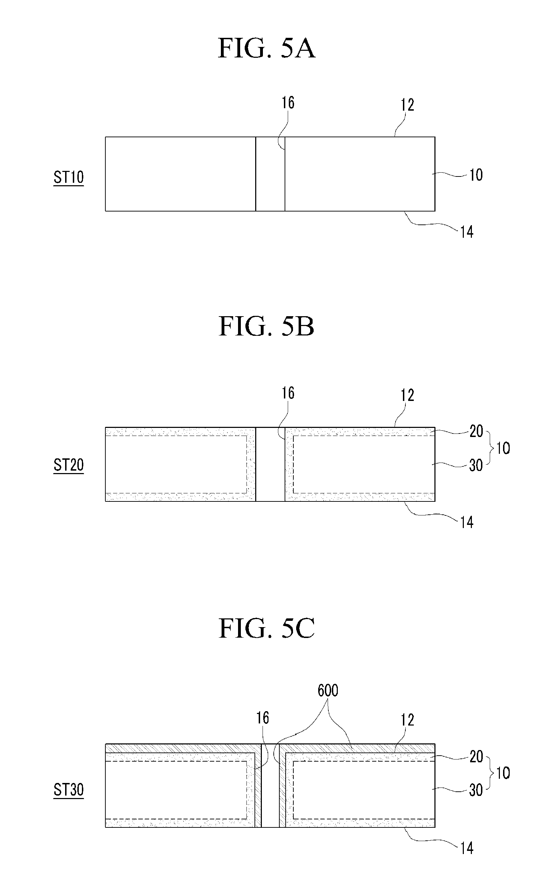

Hereinafter, an exemplary embodiment of a method for manufacturing the solar cell according to aspects of the present invention with reference to FIGs. 4 and 5A to 5i will be described. FIG. 4 is a flowchart showing a method for manufacturing a solar cell according to an exemplary embodiment of the present invention. FIG. 5A to FIG. 5I are cross-sectional views showing the method for manufacturing a solar cell according to an exemplary embodiment of the present invention.

Referring to FIG. 4, a method for manufacturing a solar cell according to aspects of the present invention includes preparing a semiconductor substrate (ST10), forming an emitter portion (ST20), forming an insulating layer (ST30), applying a paste for forming a second electrode (ST40), applying a paste for forming a first electrode portion (ST50), performing a first heat treatment (ST60), applying a paste for a second electrode portion (ST70), performing a second heat treatment (ST80), and forming an insulating part (ST90).

The method of manufacturing a solar cell according to aspects of the present invention will be further described with reference to FIGs. 5A to 5I in addition to FIG. 4.

First, as shown in FIGs. 5A and 5B, the semiconductor substrate 10 including the base portion 30 and the emitter portion 20 to form a p-n junction and having the via hole 16 extending through the semiconductor substrate 10 is prepared in the preparing the semiconductor substrate 10 (ST10) and the forming the emitter portion 20 (ST20). The semiconductor substrate 10 may be a substrate having minute protrusions and depressions formed by a texturing process in order to suppress a loss of light.

In the preparing of the semiconductor substrate 10 (ST10), the p-type semiconductor substrate 10 may be formed of crystalline silicon. The semiconductor substrate 10 includes at least one via hole 16. The via hole 16 may be formed by various methods, such as with a laser, by chemical etching, and by plasma etching.

Then, in the forming of the emitter portion (ST20), the emitter portion 20 is formed on the front surface 12 of the semiconductor substrate 10, the rear surface 14 of the semiconductor substrate 10, and the inner wall of the via hole 16. Here, a portion where the emitter portion 20 is not formed is the base portion 30.

A dopant such as phosphor, arsenic, or antimony is doped on the front surface 12, the rear surface 14, and the inner wall of the via hole 16 of the semiconductor substrate 10 in order to form an n-type emitter portion 20. A doping method, such as a high-temperature diffusion method, a spray method, a screen printing method, and an ion shower method, may be used but aspects of the present invention are not limited thereto. For example, phosphoryl chloride (POCl₃) is thermally pyrolyzed in a diffusion furnace, a phosphosilicate glass (PSG) layer (not shown) is formed on the surface of the semiconductor substrate 10, and phosphor in the PSG layer is diffused into the semiconductor substrate 10 in order to form the emitter portion 20. Then, the PSG layer is removed with diluted hydrofluoric acid (HF), and a portion in which the phosphor is unnecessarily diffused is removed by an alkaline solution such as potassium hydroxide (KOH). Further, although the emitter portion 20 and the base portion 30 are respectively described as the n-type semiconductor and the p-type semiconductor, aspects of the present invention are not limited thereto such that the emitter portion 20 may be formed of a p-type semiconductor and the base portion 30 may be formed of an n-type semiconductor.

Subsequently, as shown in FIG. 5C, an insulating layer, more specifically a layer 600 for forming an insulating layer, is formed on the front surface 12 of the semiconductor substrate 10 and inner wall of the via hole 16 (ST30). The layer 600 may be formed by a deposition method. The deposition method may be plasma enhanced chemical vapor deposition (PECVD). However, aspects of the present invention are not limited thereto. Thus, various methods can be used to form the layer 600. In the present exemplary embodiment, the deposition is performed at the side of the front surface 12 of the semiconductor substrate 10. Thus, the layer 600 is formed on the inner wall of the via hole 16 and the front surface 12 of the semiconductor substrate 10. However, aspects of the present invention are not limited thereto. Thus, the layer 600 may be formed only on the front surface 12 of the semiconductor substrate 10 or on the front surface 12, the rear surface 14, and the inner wall of the via hole 16 of the semiconductor substrate 10.

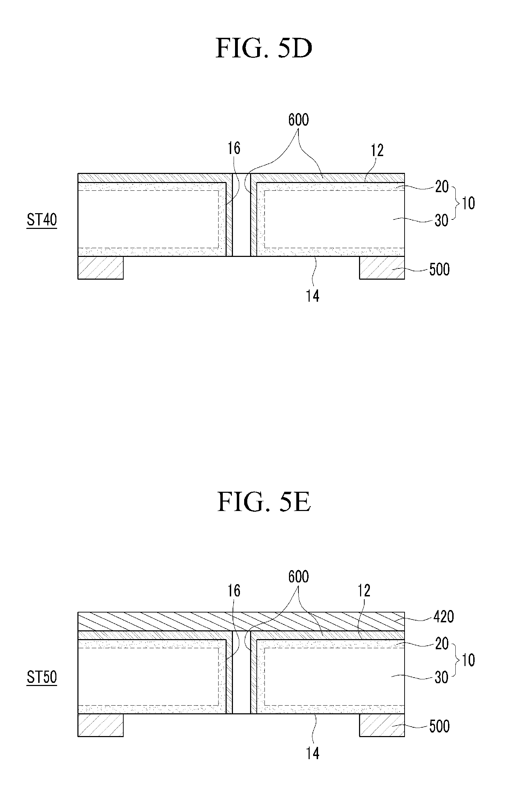

Subsequently, as shown in FIG. 5D, in the applying of the paste for forming the second electrode 50 (ST40), a paste 500 for forming the second electrode 50 is applied on the rear surface 14 of the semiconductor substrate 10. The paste 500 for forming the second electrode 50 may include a conductive material, such as aluminum. The paste 500 for forming the second electrode 50 is applied to have a shape, i.e., an elongated shape, extending in a first direction. Various methods, such as a screen-printing method, may be used as the applying method. However, aspects of the present invention are not limited thereto. Further, if the layer 600 is formed on the rear surface 14 of the semiconductor substrate 10, the layer 600 is either not formed in a region of the rear surface 14 in which the second electrode 50 is to be formed or removed from the region of the rear surface in which the second electrode 50 is to be formed before forming the second electrode 50 thereon.

Subsequently, as shown in FIG. 5E, in the applying of the paste for forming the first electrode portion 42 (ST50), a paste 420 for forming the first electrode portion 42 of the first electrode 40 (as shown in FIGs. 1 to 3) is applied on the front surface 12 of the semiconductor substrate 10. The paste 420 for forming the first electrode portion 42 may include a conductive material, such as silver, and a glass frit. The paste 420 for forming the first electrode portion 42 is applied to have a shape, i.e., an elongated shape, extending in a second direction which crosses the first direction in which the paste 500 for forming the second electrode 50 is formed. Various methods such as a screen printing method may be used as an applying method. However, aspects of the present invention are not limited thereto.

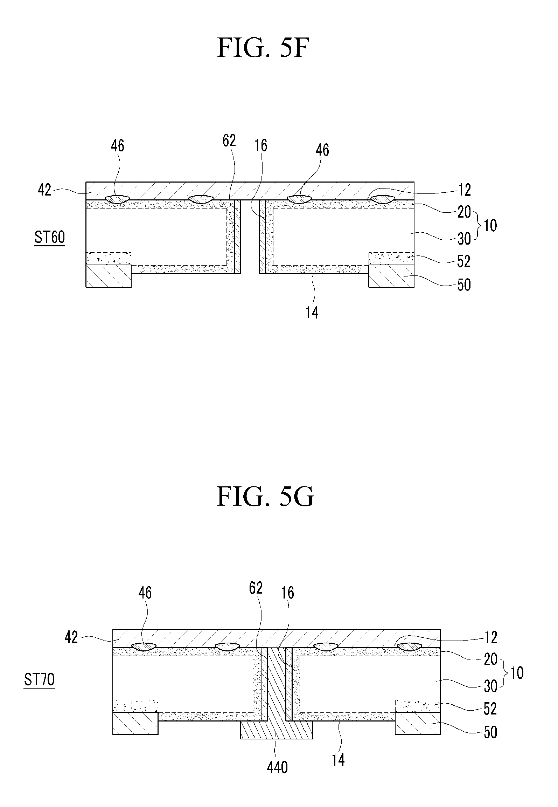

Subsequently, as shown in FIG. 5F, in the performing of the first heat treatment, the paste 420 (see FIG. 5E) for forming the first electrode portion 42 and the paste 500 for forming the second electrode 50 (see FIG. 5E) are heat-treated at a first temperature to fire them. Thereby, the first electrode portion 42 and the second electrode 50 are formed.

In the performing of the first heat treatment, the paste 420 for forming the first electrode portion 42 is heat-treated at the first temperature for generating the firing through process and is fired, and thus conductive crystals 46 are formed at an interface of the first electrode portion 42.

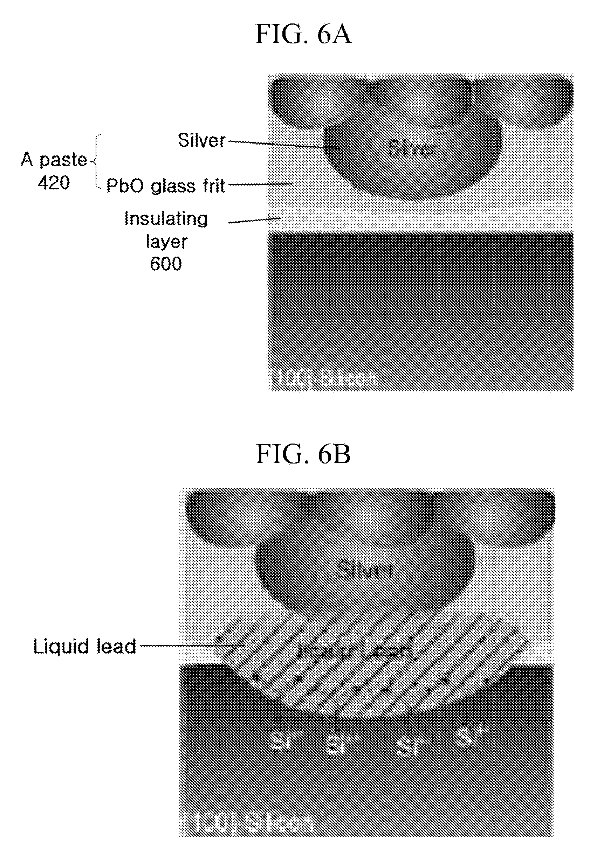

Referring to FIGs. 6A to 6E, the firing through process will be detailed more fully. FIGs. 6A to 6E are illustrations showing how to form conductive crystals by the firing through process.

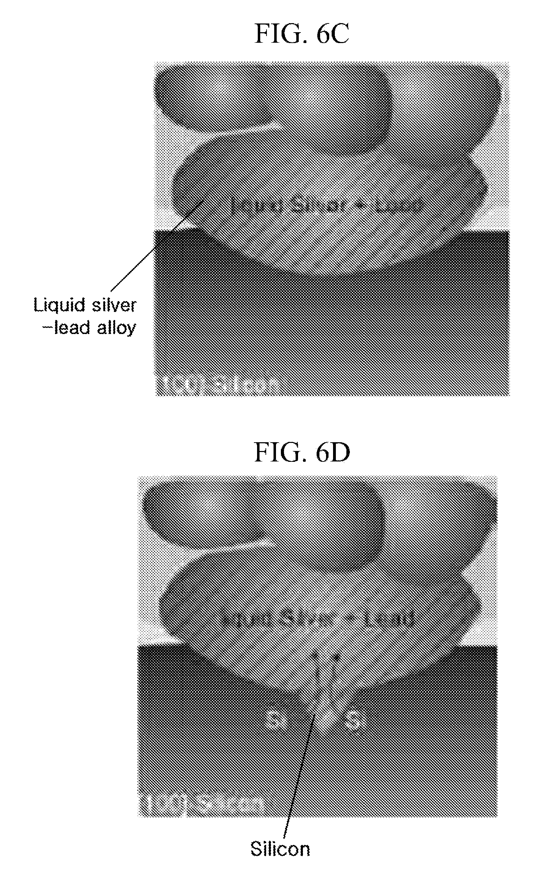

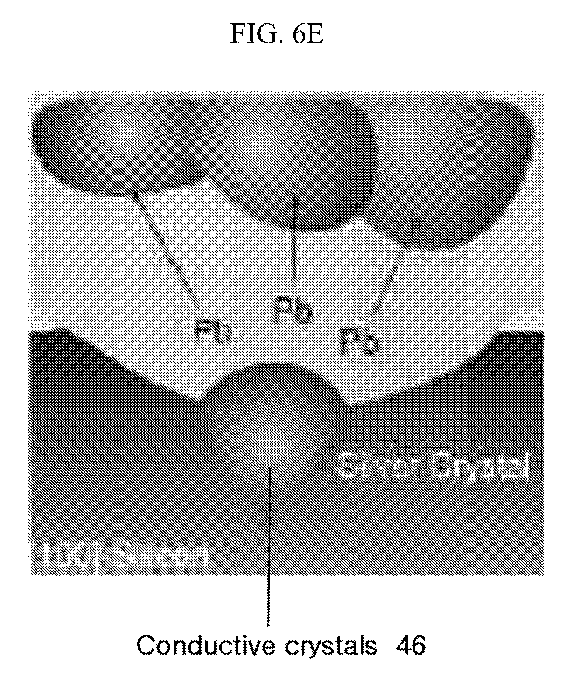

As shown in FIG. 6A, the paste 420 for forming the first electrode portion 42 is applied on the insulating layer 600 and is heat-treated at the first temperature. The paste 420 for forming the first electrode portion 42 includes silver (Ag) and glass frit including lead oxide (PbO). Then, as shown in FIG. 6B, the glass frit in the paste 420 for forming the first electrode portion 42 penetrates the insulating layer 600, and an oxidation-reduction reaction between lead (Pb) included in the glass frit and silicon (Si) included in the semiconductor substrate 10 forms liquid lead. Subsequently, as shown in FIG. 6C, the silver is dissolved in the liquid lead and a liquid silver-lead alloy is formed. As shown in FIG. 6D, the silicon then reacts with the liquid silver-lead alloy, and a plane <111> of the silicon substrate is etched to form an inverted pyramid or cone shape. A phase separation is generated as the temperature decreases. Then, as shown in FIG. 6E, the silver is recrystalized at the etched inverted pyramid or cone shape, and the conductive crystal 46 including silver are formed to have the inverted pyramid or cone shape.

Referring to FIG. 5F again, the first temperature is not limited to a specific temperature range. The first temperature is such that the firing through process can be generated according to the material of the insulating layer 600 and the material of the paste 420 for forming the first electrode portion 42.

For example, the first temperature may be 650 to 850 °C. If the first temperature is above 850°C, the materials forming the solar cell can be damaged by the high temperature and the first electrode portion 42 can damage the emitter portion because the firing through process is extreme. If the first temperature is below 650°C, the first electrode portion 42 may not be sufficiently connected to the emitter portion 20 because the firing through process is insufficient. The first temperature may be determined so that the firing through process is properly generated.

The layer 600 for forming the insulating layer is etched by the firing through process, thereby forming the insulating layer 60 including the first insulating portion 61 (see FIG. 3) and the second insulating portion 62 (see FIG. 3). The first insulating portion 61 of the insulating layer 60 is formed at a portion where the first electrode portion 42 is not formed on the front surface 12 of the semiconductor substrate 10. The second insulating portion 62 of the insulating layer 60 is formed on the inner wall 62 of the via hole 16. However, according to aspects of the present invention, the layer 600 may formed only on the front surface 12 or on the front surface 12, the rear surface 14, and the inner wall of the via hole 16 of the semiconductor substrate 10.

When the paste 420 for forming the first electrode portion 42 etches the layer 600 forming in the firing through process, it is possible that the paste 420 for forming the first electrode portion 42 does not etch the whole thickness of the layer 600. In such case, remaining portions (not shown) may partially exist between the first electrode portion 42 and the front surface 12 of the semiconductor substrate 10. As such, portions of the insulating layer 600 may remain.

The remaining portions are formed by etching the insulating layer 600. Thus, the remaining portions have a thinner thickness than a thickness of the second insulating portion 62. The first insulating portion 61, which is not etched, may have a thicker thickness than the thickness of the second insulating portion 62.

In the performing of the first heat treatment (ST60), the paste 500 for forming the second electrode 50 is also fired, and the second electrode 50 is formed. Here, the aluminum included in the paste 500 for forming the second electrode 50 is diffused in the semiconductor substrate 10, and the rear surface electric field layer 52 is formed.

Subsequently, as shown in FIG. 5G, in the applying of a paste for forming the second electrode portion 44 and the connector electrode portion 43, a paste 440 for forming the second electrode portion 44 and the connector electrode portion 43 is applied to the inside of the via hole 16 to form the connector electrode portion 43 and on the rear surface 14 of the semiconductor substrate 10 to form the second electrode portion 44 of the first electrode 40. The paste 440 for forming the second electrode portion 44 and the connector electrode portion 43 is applied in a direction parallel to the second electrode 50, i.e., the first direction. Further, the paste 440 for forming the second electrode portion 44 and the connector electrode portion 43 is applied to be spaced apart from the second electrode 50 by a predetermined distance. Various methods, such as a screen-printing method, may be used as the applying method. However, aspects of the present invention are not limited thereto.

The paste 420 (see FIG. 5F) for forming the first electrode portion 44 and the connector electrode portion 43 may be formed of the same material as the paste 440 forming the second electrode portion 42. In such case, the manufacturing process can be further simplified.

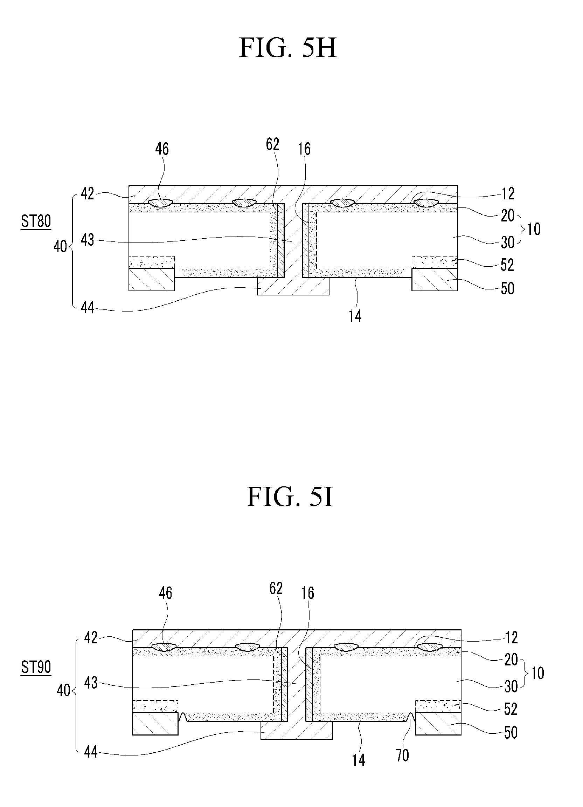

Subsequently, as shown in FIG. 5H, in the performing of the second heat treatment (ST80), the paste 440 (see FIG. 5G) for forming the second electrode portion 44 and the connector electrode portion 43 is heat-treated and is fired at a second temperature, and thus the second electrode portion 44 and the connector electrode portion 43 are formed.

The second temperature of second heat treatment (ST80) corresponds to a temperature at which the paste 440 for forming the second electrode portion 44 and the connector electrode portion 43 is fired without performing the firing through process.

Thus, the second temperature is not limited to the specific temperature range. The second temperature is such that the firing through process is not generated according to the material of the paste 440 for forming the second electrode portion 44 and the connector electrode portion 43.

For example, the second temperature may be 200 °C to 600 °C. If the second temperature is over 600°C, the shunt can be generated by the firing through process, and the firing through process may be generated at the connecting electrode portion 43 and generated again at the first electrode portion 42. If the second temperature is below 200°C, adhesion of the paste 440 of the second electrode portion 44 and the connector electrode portion 43 may be deteriorated, and the second electrode portion 44 and the connector electrode portion 43 may have a high resistance. As a result, properties of the solar cell may deteriorate.

Thus, the second temperature may be within the 200°C to 600°C. The second temperature may be within 400°C to 450°C to obtain more proper firing. According to the present exemplary embodiment, in the second heat treatment (ST80), the paste 440 for forming the second electrode portion 44 and the connector electrode portion 43 does not etch the second insulating portion 62 of the insulating layer 600 formed on the inner wall of the via hole 16 or on the rear surface 14 of the substrate 10 if formed thereon. Further, the paste 440 for forming the second electrode portion 44 and the connector electrode portion 43 is fired in a state in which the paste 440 for forming the second electrode portion 44 and the connector electrode portion 43 is maintained. Accordingly, the second electrode portion 44 and the connector electrode portion 43 and the emitter portion 20 form surface opposing structures.

In the case that the insulating layer 600 does not initially include the second insulating portion 62, the second electrode portion 44 and the connector electrode portion 43 are in direct contact with the emitter portion 20 in the surface opposing structure.

Subsequently, as shown in FIG. 5I, in the forming of the insulating part 70, the insulating part 70 is formed by a laser and insulates the second electrode portion 44 from the second electrode 50.

According to the method for manufacturing the solar cell of the present exemplary embodiment, the performing of the second heat treatment (ST80) is performed at the second temperature which is lower than the first temperature of the performing of the first hear treatment (ST60). Thus, the firing through process is generated in the first heat treatment (ST60), whereas the firing through process is not generated in the second heat treatment (ST80).

Accordingly, the first electrode portion 42, formed by the firing through process, can be electrically connected to the emitter portion 20 and have excellent characteristics. In addition, the shunt, which may be generated in the step of forming the second electrode portion 44 and the connector electrode portion 43 by the firing through process, can be prevented. Thus, the shunt resistance of the solar cell can be minimized, and a fill factor and energy conversion efficiency can be improved.

Further, in the present exemplary embodiment, a separate process is not added, and the manufacturing process is not changed. Thus, the solar cell having the excellent energy conversion efficiency can be formed by a simple manufacturing process.

Hereinafter, the present invention will be described in more detail referring to an experimental example and a comparative example. The experimental example is provided only for describing the present invention more fully, and aspects of the present invention are not limited thereto.

### Experimental Example

A p-type silicon semiconductor substrate having a thickness of 240µm and including a via hole having a diameter of 100µm was formed. The semiconductor substrate had minute protrusions and depressions formed by a texturing process. Phosphoryl chloride (POCl₃) was thermally pyrolyzed in a diffusion furnace, a phosphosilicate glass (PSG) layer having a thickness of 0.5µm was formed on the surface of the semiconductor substrate, and phosphor in the PSG layer was diffused into the semiconductor substrate such that an emitter portion was formed. The PSG was removed with diluted hydrofluoric acid (HF), and an unwanted portion among the portion where the phosphor was diffused was removed with a potassium hydroxide (KOH) solution.

An anti-reflective layer consisting of silicon nitride and having a thickness of 75nm was formed on a front surface of the semiconductor substrate by plasma enhanced chemical vapor deposition.

A paste for forming a second electrode including aluminum was applied on the rear surface of the semiconductor substrate by screen printing. A first heat treatment was performed at a temperature of 750°C, and a second electrode and a first electrode portion were formed. The first electrode portion was electrically connected to the emitter portion by the firing through process, and a rear electric field layer was formed at a portion adjacent to the second electrode by the firing through process.

A second electrode portion and a connector electrode portion were formed by applying a paste for forming the second electrode portion and the connector electrode portion including silver on the rear surface and the inner wall of the via hole of the semiconductor substrate by screen printing. A second heat treatment was performed at a temperature of 450°C without the firing through process, and the second electrode portion and the connector electrode portion were formed. The insulating part was formed on the rear surface of the semiconductor substrate by a laser, thereby completing the manufacturing of the solar cell.

### Comparative Example

The Comparative Example solar cell was manufactured by the same method as in the Experimental Example, excepting that the second heat treatment was performed at a temperature of 750°C. The current density (Jsc), open circuit voltage (Voc), shunt resistance (Rsh), fill factor (FF), and energy conversion efficiency (Eff) of the solar cells according to the Experimental Example and Comparative Example are shown in Table 1.

**(Table 1)**

| | Jsc [mA/cm²] | Voc [mV] | Rsh [Ohm*cm²] | FF [%] | Eff [%] |
|---|---|---|---|---|---|
| Experimental Example | 35.51 | 608 | 2.2888 | 76.1 | 16.5 |
| Comparative Example | 35.39 | 608 | 1.3225 | 70.7 | 15.3 |

The solar cell according to the Experimental Example had a larger fill factor (FF) than that of the solar cell according to the Comparative Example by about 5%. This appears to be because of the larger shunt resistance (Rsh) of the Experimental Example. In addition, it can be seen that the solar cell according to the Experimental Example had higher energy conversion efficiency than that of the solar cell according to the comparative example by about 1%.

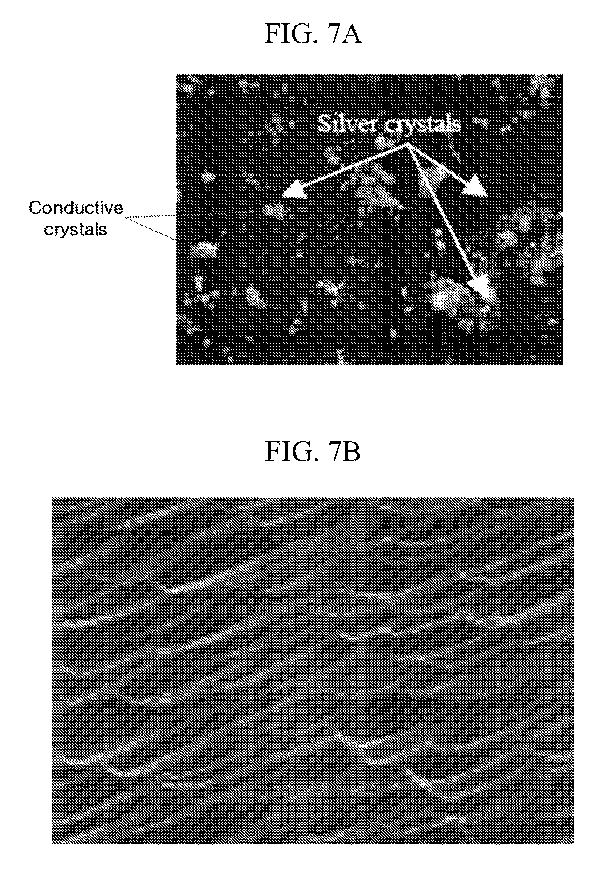

FIG. 7A is a picture of an interface of a first electrode portion of the first electrode formed under the same conditions as in the Experimental Example, except that the texturing process was not performed. FIG. 7B is a picture of an interface of a second electrode portion of the first electrode formed under the same conditions as in the Experimental Example. Because conductive crystals cannot be seen well when the protrusions and depressions are generated by the texturing process, a picture of the interface of the first electrode portion in the state that the texturing process was not performed is shown in FIG. 7A. As shown in FIG. 7A, conductive crystals, that is, silver crystals, are formed at the interface of the first electrode portion of the first electrode. Also, as shown in FIG. 7B, conductive crystals are not formed at the interface of the second electrode portion of the first electrode. For reference, the surface is rough in FIG. 7B because of the texturing of the surface, not because of conductive crystals.

Although a few embodiments of the present invention have been shown and described, it would be appreciated by those skilled in the art that changes may be made in this embodiment without departing from the scope of the invention as defined in the claims.

## Claims

1. A solar cell, comprising:
a semiconductor substrate (10) including an emitter portion (20), a base portion (30) and a via hole (16), the semiconductor substrate (10) having a first surface (12) on which light is to be incident and a second surface (14) opposite to the first surface (12);
wherein the emitter portion (20) forms at least a portion of the first surface (12), at least a portion of the second surface (14), and at least a portion of a wall of the via hole (15) of the semiconductor substrate (10); and
wherein the base portion (30) forms a p-n junction (20) with the emitter portion in the semiconductor substrate (10);
a first electrode (40) electrically connected to the emitter portion(20); and
a second electrode (50) electrically connected to the base portion (30), wherein the first electrode (40) comprises:
a first electrode portion (42) formed on the first surface (12) of the semiconductor substrate (10),
a second electrode portion (44) formed on the second surface (14) of the semiconductor substrate (10), and
a connecting electrode portion (43) connecting the first electrode portion (42) and the second electrode portion (44) through the via hole (16), and
wherein a first interface (42a) between the first electrode portion (42) and the emitter portion (20) has a different structure from a second interface (44a) between the second electrode portion (44) and the emitter portion (20) and between the connecting electrode portion (43) and the emitter portion(30).

2. The solar cell of claim 1, wherein a plurality of conductive crystals (46) electrically connect the emitter portion (20) and the first electrode portion (42) of the first electrode (40), and the plurality of conductive crystals (46) is formed at the first interface (42a), and the crystals of the plurality of conductive crystals (46) are spaced apart from each other in the plane of the first interface (42a).

3. The solar cell of claim 2, wherein the conductive crystals have pyramid or cone shapes having their apexes directed towards the emitter portion (20).

4. The solar cell of any one of the preceding claims, wherein the second interface (44a) and the emitter portion (20) form a surface opposing structure in which no conductive crystals are formed.

5. The solar cell of any one of the preceding claims, further comprising:
an insulating layer (60) including a first insulating portion formed on the first surface (12) of the semiconductor substrate (10) and a second insulating portion (61) formed on the wall of the via hole (16),
wherein the second insulation portion (61) is disposed between the connecting electrode portion (43) and the emitter portion (20).

6. A method for manufacturing a solar cell, comprising:
preparing a semiconductor substrate (10) including a base portion (30) and an emitter portion (20) to form a p-n junction, the semiconductor substrate (10) having a via hole (16);
applying a first paste (420) on a first surface (12) of the semiconductor substrate (10);
performing a first heat treatment to the first paste (420) at a first temperature to form a first electrode portion (42) of a first electrode (40);
applying a second paste (440) on a second surface (14) of the semiconductor substrate (10) and on an inner wall of the via hole (16); and
performing a second heat treatment to the second paste (440) at a second temperature, the second temperature being lower than the first temperature, to form a second electrode portion (44) and a connecting electrode portion (43) of the first electrode (40).

7. The method of claim 6, wherein the first paste (420) contains metal and, in the performing of the first heat treatment, a plurality of conductive crystals are formed from the metal in the first paste to electrically connect the emitter portion (20) to the first electrode portion (42) wherein the crystals are spaced apart from each other.

8. The method of claim 6 or 7, wherein, the second paste (440) contains metal and the second heat treatment is performed at a temperature insufficient to form conductive crystals from the metal contained in the second paste

9. The method of any one of claims 6 to 8, further comprising:
forming an insulating layer (60) on the first surface (12) of the semiconductor substrate (10) and on the inner wall of the via hole (16) between the preparing of the semiconductor substrate (10) and the applying of the first paste (420);
wherein the first paste (420) etches a first insulating portion of the insulating layer (60) formed on the first surface (12) of the semiconductor substrate (10) in the performing of the first heat treatment, and
the second paste (440) does not etch a second insulating portion (61) of the insulating layer formed on the inner wall of the via hole (16) in the performing of the second heat treatment.

10. The method of any one of claims 6 to 9, wherein the first and second paste comprise the same material.

11. The method of any one of claims 6 to 10, further comprising:
applying a paste (500) for forming a second electrode (50) on the second surface (14) of the semiconductor substrate (10) before the performing of the first heat treatment, wherein, in the performing of the first heat treatment, the paste (500) for forming the second electrode (50) is heat-treated to form the second electrode (50).

12. The method of any one of claims 6 to 11, wherein the first temperature is 650°C to 850°C.

13. The method of any one of claims 6 to 12, wherein the second temperature is 200°C to 600°C.

14. A solar cell, comprising:
a substrate (10) having a first surface (12) on which light is to be incident and a second surface (14), and the substrate (10) including a p-type semiconductor and an n-type semiconductor;
a first electrode (40) having at least a portion (42) disposed on the first surface (12) of the substrate (10);
conductive crystals (46) disposed between the portion (42) of the first electrode (40) and the first surface (12) of the substrate (10) to electrically connect the first electrode (40) to one of the p-type semiconductor and the n-type semiconductor; and
a second electrode (50) electrically connected to the other of the p-type semiconductor and the n-type semiconductor.

15. A method for manufacturing a solar cell, the method comprising:
preparing a semiconductor substrate (10) having a first surface (12) on which light is to be incident and a second surface (14), the semiconductor substrate (10) including a p-type semiconductor and an n-type semiconductor;
applying a first electrode paste (420) on the first surface (12) of the semiconductor substrate (10), the first electrode paste (420) including silver and PbO;
heat treating the first electrode paste (420) at a temperature sufficient to induce a reaction between the lead of the first electrode paste and the silicon of one of the p-type semiconductor and the n-type semiconductor to form a liquid lead in which the silver of the first electrode paste dissolves and to form a first electrode; and
separating and crystallizing the dissolved silver from the liquid lead mixture to form electrical connections between the first electrode and the one of the p-type semiconductor and the n-type semiconductor.
